# DEMANDE DE BREVET EUROPEEN

(11) **EP 1 646 085 A2**
(43) Date de publication de la demande: **12.04.2006**
(21) Numéro de dépôt: 05108774.0
(22) Date de dépôt: 22.09.2005
(51) Int. Cl.: H01L 23/544

(54) **Génération déterministe d'un numéro d'identification d'un circuit intégré**

(30) Priorité: 23.09.2004 FR 0452141
(71) Demandeur: ST MICROELECTRONICS S.A., 92120 Montrouge (FR)
(72) Inventeur: MARINET, Fabrice, 13790, CHATEAUNEUF LE ROUGE (FR)
(74) Mandataire: de Beaumont, Michel

(57) **Abrégé**

L'invention concerne la génération d'un numéro d'identification d'une puce (2) portant au moins un circuit intégré, consistant à provoquer une découpe d'au moins un tronçon conducteur (4) par découpe de la puce parmi plusieurs premiers tronçons conducteurs parallèles entre eux et perpendiculaires à au moins un bord de la puce, les premiers tronçons étant individuellement connectés, par au moins une de leurs extrémités, à la puce et présentant des longueurs différentes les uns des autres, la position du trait de coupe (3) par rapport au bord de la puce conditionnant le numéro d'identification.

## Description

### Domaine de l'invention

La présente invention concerne de façon générale l'identification de puces de circuit(s) intégré(s) au moyen d'un numéro qui différencie une puce d'une autre avec un certain degré de reproduction des numéros.

L'invention concerne plus particulièrement une génération déterministe d'un identifiant (numéro d'identification), c'est-à-dire une génération volontaire d'un nombre choisi.

### Exposé de l'art antérieur

Les méthodes connues pour générer de façon déterministe un identifiant d'une puce de circuit intégré utilisent généralement une mémoire non volatile du circuit et y stockent un nombre par écriture dans cette mémoire.

Cette écriture requiert une étape particulière que ce soit lors de la fabrication (masque d'écriture dans une mémoire ROM) ou après fabrication (processus électrique ou optique d'écriture).

De plus, le stockage du numéro d'identification requiert une zone mémoire interne à la puce de circuit intégré qui prend de la place.

### Résumé de l'invention

La présente invention vise à proposer une méthode de génération et d'enregistrement d'un numéro d'identification d'une puce de circuit.

L'invention vise plus particulièrement à permettre la génération sans étape particulière dédiée.

L'invention vise également préférentiellement à éviter un stockage non volatile dans des circuits intégrés actifs de la puce.

L'invention vise également à proposer une génération déterministe, c'est-à-dire dont le numéro est choisi lors de sa génération.

L'invention vise également à proposer une solution particulièrement simple à exploiter en terme de lecture du nombre généré.

Pour atteindre ces objets ainsi que d'autres, la présente invention prévoit un procédé de génération d'un numéro d'identification d'une puce portant au moins un circuit intégré, consistant à provoquer une découpe d'au moins un tronçon conducteur par découpe de la puce parmi plusieurs premiers tronçons conducteurs parallèles entre eux et perpendiculaires à au moins un bord de la puce, les premiers tronçons étant individuellement connectés, par au moins une de leurs extrémités, à la puce et présentant des longueurs différentes les uns des autres, la position du trait de coupe par rapport au bord de la puce conditionnant l'identifiant.

Selon un mode de mise en oeuvre de la présente invention, l'écart minimum entre deux premiers tronçons est supérieur aux tolérances de positionnement de la découpe par rapport à la puce.

Selon un mode de mise en oeuvre de la présente invention, les premiers tronçons conducteurs sont interconnectés dans la puce à une borne d'application d'un signal d'excitation sur une première de leurs extrémités, leurs deuxièmes extrémités respectives fournissant des bits du numéro d'identification.

Selon un mode de mise en oeuvre de la présente invention, les premiers tronçons conducteurs sont reliés les uns aux autres successivement par des tronçons secondaires perpendiculaires, les longueurs des différents premiers tronçons étant croissantes depuis une première extrémité d'application d'un signal d'excitation.

Selon un mode de mise en oeuvre de la présente invention, le ou les tronçons conducteurs sont réalisés dans au moins une couche enterrée.

Selon un mode de mise en oeuvre de la présente invention, le ou les tronçons conducteurs sont réalisés dans au moins un niveau de métallisation.

L'invention prévoit également une puce de circuit intégré comportant, sur au moins un côté, au moins deux tronçons conducteurs dont deux bornes d'extrémité sont reliées à l'intérieur de la puce pour générer un numéro d'identification de celle-ci qui dépend de la position d'un trait de découpe par rapport au bord correspondant de la puce.

Selon un mode de réalisation de la présente invention, la puce comporte un circuit d'excitation du trajet conducteur à une de ses extrémités et de lecture de la tension à son autre extrémité.

### Brève description des dessins

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles :
la figure 1 est une vue schématique de dessus d'une plaquette sur laquelle ont été fabriqués des circuits intégrés ;
la figure 2 est une vue détaillée d'une puce de circuit intégré de la figure 1 faisant apparaître des moyens de génération et de mémorisation d'un numéro d'identification selon un premier mode de réalisation de l'invention ;
la figure 3 est une vue partielle de dessus d'une puce de circuit intégré illustrant un deuxième mode de mise en oeuvre d'une génération d'un numéro d'identification d'une puce de circuit intégré selon la présente invention ; et
la figure 4 illustre, de façon plus détaillée, un élément de mémorisation selon le premier mode de mise en oeuvre de l'invention.

### Description détaillée

Les mêmes éléments ont été désignés par les mêmes références aux différentes figures qui ont été tracées sans respect d'échelle. Par souci de clarté, seuls les éléments utiles à la compréhension de l'invention ont été représentés aux figures et seront décrits par la suite. En particulier, l'exploitation faite par le circuit intégré de son numéro d'identification, que ce soit dans des applications de reconnaissance, de chiffrement ou autres n'a pas été détaillée, l'invention étant compatible avec toute exploitation classique d'un numéro d'identification mémorisé dans une puce de circuit intégré.

Une caractéristique de la présente invention est de générer un numéro d'identification d'une puce de circuit intégré lors de son individualisation par rapport aux autres puces avec laquelle elle est fabriquée sur une plaquette de circuits intégrés.

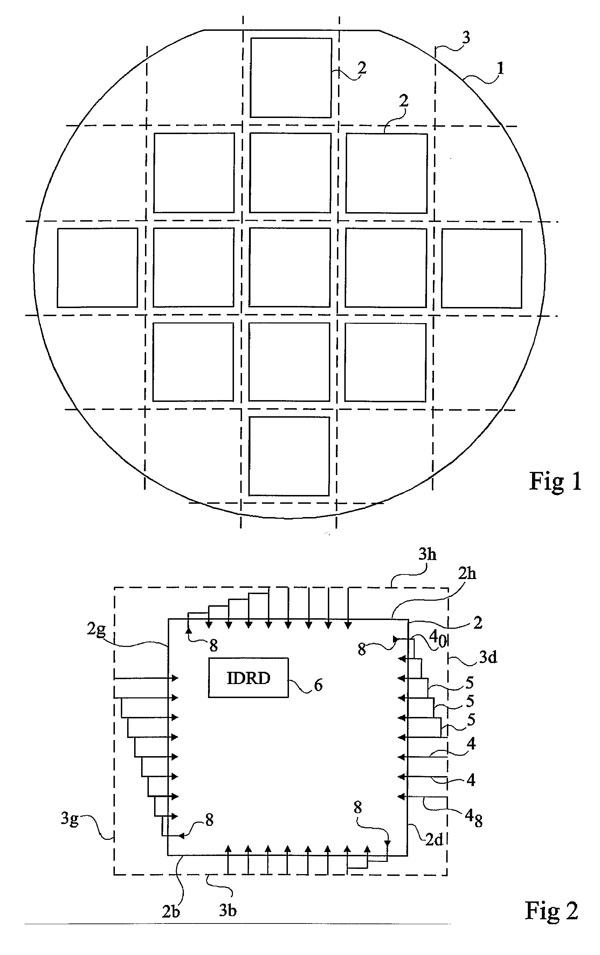

La figure 1 est une vue schématique de dessus d'une plaquette 1 de circuits intégrés sur laquelle ont été réalisés plusieurs circuits ou puces 2. De façon arbitraire, les circuits ont en figure 1 été représentés carrés mais n'importe quelle autre forme de circuit intégré convient à l'invention. De plus, on suppose que des circuits identiques sont réalisés sur la plaquette 1 mais l'invention s'applique également au cas où des puces différentes sont réalisées sur la même plaquette pourvu que les chemins de découpe soient respectés comme on le verra par la suite. En outre, on fera référence à une puce de circuit intégré sachant que chaque puce peut comporter un ou plusieurs circuits actifs et/ou passifs.

En fin de fabrication, les puces de circuit intégré 2 sont individualisées en étant découpées (par exemple au moyen d'une scie) dans des chemins 3 entre les puces 2. L'invention sera décrite par la suite en relation avec une découpe par scie, mais est plus généralement compatible avec toute méthode classique de découpe de circuits intégrés.

Une caractéristique de la présente invention est de prévoir, entre les puces, c'est-à-dire dans les chemins de découpe, plusieurs trajets électriquement conducteurs susceptibles d'être interrompus lors de la découpe.

La figure 2 représente, par une vue de dessus très schématique, une puce 2 de circuit intégré après découpe selon un premier mode de réalisation préféré de la présente invention.

Dans cet exemple, on forme, lors de la fabrication des circuits intégrés 2 et dans les chemins de découpe, plusieurs tronçons conducteurs 4 parallèles entre eux et perpendiculaires au bord 2g, 2h, 2d ou 2b de la puce 2 auquel ils sont respectivement raccordés. Les tronçons électriques 4 d'un même bord sont par ailleurs reliés, au moins par groupe, successivement les uns aux autres au moyen de tronçons conducteurs 5, perpendiculaires aux tronçons 4.

Selon l'invention, les positions respectives des tronçons de liaison 5 par rapport au bord de la puce auquel sont raccordés les tronçons 4 correspondants sont à des distances différentes (croissantes depuis un premier tronçon 4₀ jusqu'à un dernier tronçon 4₈).

Lors de la découpe de la puce de circuit intégré, le trait de coupe 3g, 3h, 3d ou 3b parallèle au bord 2g, 2h, 2d ou 2b concerné interrompt plusieurs tronçons 4 et, par conséquent, supprime une ou plusieurs liaisons 5 vers les tronçons de longueurs supérieures.

Il en découle que, selon la position du trait de coupe 3 par rapport au bord de la puce, le nombre de tronçons conducteurs reliés les uns aux autres par un tronçon 5 perpendiculaire est différent. Il suffit alors d'exciter, par exemple au moyen d'une tension continue fournie par un circuit 6 (IDRD) que comporte la puce 2, l'extrémité 8 du tronçon le plus court 4₀ et de mesurer les tensions respectives aux extrémités de tous les autres tronçons du même bord pour obtenir, directement de façon binaire, un mot (ici sur 8 bits) constitutif de l'identifiant de la puce de circuit intégré. La puce 2 comporte des moyens d'exploitation (mesure et interprétation) de l'identifiant, par exemple, contenus dans le circuit 6.

De préférence, la même structure est reproduite sur au moins deux côtés, de préférence sur les quatre côtés ou plus dans le cas d'une puce non parallélépipédique. Les mots numériques obtenus sont concaténés (en variante, combinés). On rend alors moins fréquente la reproduction d'un même numéro d'identification pour une même plaquette de circuits intégrés dans la mesure où, si deux puces ont le même numéro par l'un de leurs bords pour avoir subi un même trait de coupe, il suffit de prévoir un nombre différent sur un trait de coupe dans une autre direction pour que ces deux puces n'aient pas le même identifiant final.

Les éléments prévus sur les différents côtés ne comportent pas nécessairement le même nombre de tronçons (donc de bits).

Les tolérances en positionnement des traits de coupe 3 dans les trajets sur une plaquette 1 sont donc mis à profit par l'invention pour individualiser les identifiants des puces les unes par rapport aux autres. Pour permettre une prédétermination du numéro d'identification, les écarts de longueurs entre les différents trajets sont choisis en fonction de la largeur du trait de coupe (par exemple, de la scie) et de ses tolérances de positionnement. En pratique, cela revient à prévoir un écart e minimum entre les tronçons 5, dans la direction des tronçons 4, supérieur aux tolérances de positionnement de la découpe par rapport aux bords de la puce. Cette condition permet de garantir le caractère déterministe de la génération de l'identifiant.

A titre d'exemple particulier, les scies les plus couramment utilisées sont conçues pour des chemins de découpe (écart entre deux puces 2 d'une même plaquette 1) de l'ordre de 100 µm) et le trait de coupe (correspondant à la largeur de la scie) à une épaisseur de l'ordre de 20 à 25 µm. Les tolérances dans l'alignement de la scie sont de l'ordre de 5 µm, ce qui impose dans cet exemple un écart e de 10 µm pour différencier les longueurs des tronçons conducteurs. En variante, on pourra utiliser des scies de différentes épaisseurs.

Le nombre de trajets conducteurs générant et mémorisant les numéros d'identification dépend de l'application, de la taille de la puce et de la taille des chemins de découpe.

On notera que, bien qu'un trait de découpe par scie provoque généralement un écaillage en face avant de la puce, cet écaillage n'est pas gênant pourvu d'être compris dans les tolérances de découpe, ce qui est en pratique le cas.

Dans l'exemple de la figure 2, en supposant que la présence d'une tension est lue comme un état 1, le côté 2d de la puce fournit une valeur numérique 11111000. Le côté 2h de la puce fournit une valeur 11110000. Le côté gauche 2g fournit une valeur 11111110. Le côté bas 2b fournit une valeur 11000000.

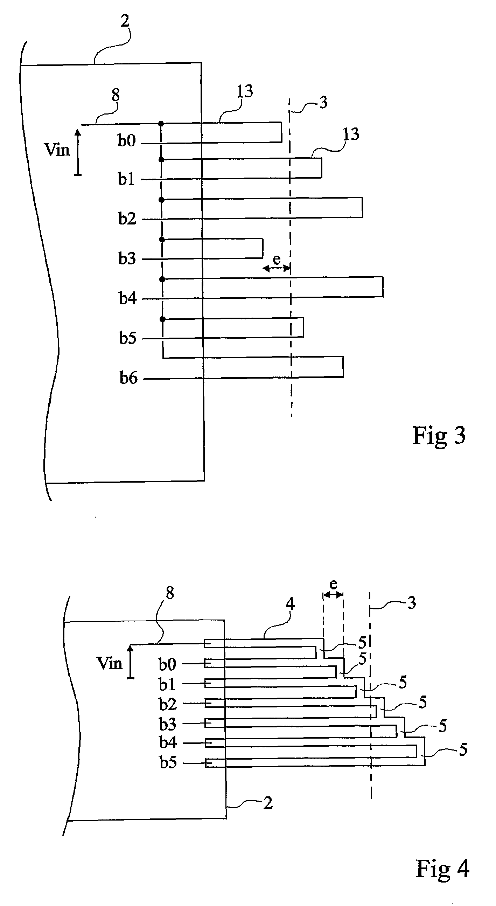

La figure 3 représente un deuxième mode de mise en oeuvre de l'invention dans lequel des trajets individuels 13 sont connectés en parallèle à une borne 8 d'application d'une tension d'entrée Vin, leurs autres extrémités respectives étant lisibles individuellement par le circuit de lecture (6, figure 2) que comporte la puce 2 et fournissent directement des états zéro ou un constituant des bits (dans cet exemple, b0 à b6) du numéro d'identification.

Comme les tronçons 13 sont individualisés, il n'est pas requis comme dans le premier mode de mise en oeuvre qu'ils soient de longueur croissante. Dans le mode de réalisation de la figure 3, la position du trait de coupe 3 interrompt certains des tronçons conducteurs qui fournissent alors des premiers états binaires (par exemple zéro) tandis que les tronçons non interrompus fournissent des états complémentaires (par exemple, 1) .

Avec cette convention, les sept bits de l'élément d'identification de la figure 3 fournissent la valeur 1001000.

La figure 4 représente une vue agrandie des tronçons conducteurs 4 du premier mode de mise en oeuvre de la figure 2 en supposant que l'élément fournit 5 bits b0 à b5. A la différence du mode de réalisation de la figure 3, le trait de coupe ne conditionne pas individuellement les états mais fixe le rang du bit du mot à partir duquel l'état change. En figure 4, une largeur des tronçons conducteurs 4 et 5 a été illustrée.

Dans cet exemple, les cinq bits de l'élément d'identification réalisé fournissent la valeur 111000.

Un avantage de la présente invention est qu'elle permet de générer de façon extrêmement simple des numéros d'identification de puces de circuit intégré.

Un autre avantage de la présente invention est que la mémorisation du numéro d'identification, généré en fin de fabrication par la découpe de la puce, est intrinsèque à la puce et ne nécessite aucun élément actif. Ce numéro pourra toutefois être également mémorisé dans la puce.

Un autre avantage de l'invention est que la génération ne requiert pas d'étape de fabrication dédiée, la réalisation des trajets conducteurs s'effectuant en même temps que les connexions de la puce dans ses niveaux conducteurs et la génération et mémorisation de l'identifiant s'effectuant en même temps que la découpe de la puce.

Un autre avantage de l'invention est que la lecture de l'identifiant est particulièrement simple (de simples comparateurs ou portes logiques suffisent).

Les éléments de génération et de mémorisation ne sont pas forcément répartis sur l'intégralité des côtés des puces. Ils peuvent se trouver localisés sur une portion de chaque bord des puces découpées.

La mise en oeuvre de l'invention est compatible avec la mise en boîtier postérieure à la découpe d'une puce de circuit intégré, sans précaution particulière.

En variante, différents trajets pourront être prévus dans plusieurs niveaux conducteurs. Une différenciation supplémentaire pourra alors provenir de l'angle de découpe de l'outil de coupe si les tolérances angulaires sont compatibles.

On pourra réaliser les tronçons conducteurs dans des couches enterrées (couches actives) ou dans des niveaux de métallisation supérieurs (niveau d'interconnections). Un avantage des couches enterrées est qu'elles évitent l'apparition de copeaux lors de la découpe comme c'est le cas pour les niveaux métalliques.

Bien entendu, la présente invention est susceptible de diverses variantes et modifications qui apparaîtront à l'homme de l'art. En particulier, l'adaptation des dimensions à donner aux trajets conducteurs de génération du numéro d'identification en fonction des tailles de puces et des tolérances des outils de coupe utilisés est à la portée de l'homme du métier à partir des indications fonctionnelles données ci-dessus. De plus, bien que l'invention ait été décrite en relation avec des tronçons conducteurs parallèles et/ou perpendiculaires aux bords de la puce pour être parallèles et/ou perpendiculaires aux traits de coupe, on pourra prévoir des tronçons en biais pourvu que ce biais soit compatible avec une différenciation entre plusieurs puces suite à la découpe. En outre, la réalisation pratique d'un circuit 6 d'exploitation des éléments d'identification de l'invention par excitation électrique et lecture des résultats fait appel à des composants électroniques classiques et est à la portée de l'homme du métier en fonction de l'application.

## Revendications

1. Procédé de génération d'un numéro d'identification d'une puce (2) portant au moins un circuit intégré, **caractérisé en ce qu'**il consiste à provoquer une découpe d'au moins un tronçon conducteur (4, 13) par découpe de la puce parmi plusieurs premiers tronçons conducteurs parallèles entre eux et perpendiculaires à au moins un bord de la puce, les premiers tronçons étant individuellement connectés, par au moins une de leurs extrémités, à la puce et présentant des longueurs différentes les uns des autres, la position du trait de coupe (3) par rapport au bord de la puce conditionnant l'identifiant.

2. Procédé selon la revendication 1, dans lequel l'écart minimum (e) entre deux premiers tronçons (4, 13) est supérieur aux tolérances de positionnement de la découpe par rapport à la puce (2).

3. Procédé selon la revendication 1, dans lequel les premiers tronçons conducteurs (13) sont interconnectés dans la puce à une borne (8) d'application d'un signal d'excitation sur une première de leurs extrémités, leurs deuxièmes extrémités respectives fournissant des bits du numéro d'identification.

4. Procédé selon la revendication 1, dans lequel les premiers tronçons conducteurs (4) sont reliés les uns aux autres successivement par des tronçons secondaires (5) perpendiculaires, les longueurs des différents premiers tronçons étant croissantes depuis une première extrémité (8) d'application d'un signal d'excitation.

5. Procédé selon la revendication 1, dans lequel le ou les tronçons conducteurs (4, 13) sont réalisés dans au moins une couche enterrée.

6. Procédé selon la revendication 1, dans lequel le ou les tronçons conducteurs (4, 13) sont réalisés dans au moins un niveau de métallisation.

7. Puce de circuit intégré comportant, sur au moins un côté, au moins deux tronçons conducteurs (4, 13) dont deux bornes d'extrémité (8, 9) sont reliées à l'intérieur de la puce pour générer un numéro d'identification de celle-ci qui dépend de la position d'un trait de découpe (3) par rapport au bord correspondant de la puce.

8. Puce selon la revendication 7, comportant un circuit (6) d'excitation du trajet conducteur à une (8) de ses extrémités et de lecture de la tension à son autre extrémité.

9. Puce selon la revendication 7, obtenue par la mise en oeuvre du procédé selon l'une quelconque des revendications 1 à 8.
